# EUROPÄISCHE PATENTSCHRIFT

(11) **EP 2 195 863 B1**
(45) Veröffentlichungstag und Bekanntmachung des Hinweises auf die Patenterteilung: **23.05.2018**
(21) Anmeldenummer: 08787081.2
(22) Anmeldetag: 11.08.2008
(51) Int. Cl.: H01L 33/50, H01L 33/62

(54) **VERFAHREN ZUM HERSTELLEN EINES OPTOELEKTRONISCHEN BAUELEMENTS UND OPTOELEKTRONISCHES BAUELEMENT**
METHOD FOR PRODUCING AN OPTOELECTRONIC COMPONENT AND OPTOELECTRONIC COMPONENT
PROCÉDÉ DE FABRICATION D'UN COMPOSANT OPTOÉLECTRONIQUE, ET COMPOSANT OPTOÉLECTRONIQUE

(30) Priorität: 07.09.2007 DE 102007042642
(43) Veröffentlichungstag der Anmeldung: 16.06.2010
(73) Patentinhaber: Osram Opto Semiconductors Gmbh, 93055 Regensburg (DE)
(72) Erfinder: BERBEN, Dirk, 86399 Bobingen (DE); FIEDLER, Tim, 81377 München (DE); JERMANN, Frank, 86343 Königsbrunn (DE); ZACHAU, Martin, 82269 Geltendorf (DE)
(74) Vertreter: Lehner, Martin
(86) Internationale Anmeldenummer: PCT/EP2008/060506
(87) Internationale Veröffentlichungsnummer: WO 2009/033905

(56) Entgegenhaltungen:
- EP-A- 1 267 424
- DE-A1- 10 340 004
- JP-A- 2003 046 141
- US-A1- 2002 185 965
- US-A1- 2004 135 162
- US-A1- 2004 211 970
- US-A1- 2006 255 355

## Beschreibung

Die vorliegende Anmeldung betrifft ein Verfahren zum Herstellen eines optoelektronischen Bauelements. Das Bauelement weist einen Lumineszenzdiodenchip auf, der geeignet ist, eine elektromagnetische Primärstrahlung zu emittieren. Der Lumineszenzdiodenchip ist in dem herzustellenden optoelektronischen Bauelement mit einem Lumineszenzkonversionsmaterial versehen, das mindestens einen Leuchtstoff enthält, der geeignet ist, die Primärstrahlung zumindest teilweise in eine Sekundärstrahlung zu konvertieren. Die Anmeldung betrifft zudem ein derartiges optoelektronisches Bauelement.

In der WO 2006/034663 A1 ist ein Verfahren zum Herstellen von Lumineszenzdiodenchips offenbart, die mit einem Lumineszenzkonversionsmaterial versehen sind. Die mit dem Lumineszenzkonversionsmaterial versehenen Lumineszenzdiodenchips weisen Kontaktelektroden auf, die jeweils zumindest teilweise frei von dem Lumineszenzkonversionsmaterial sind. Dadurch können die Chips wie herkömmliche Lumineszenzdiodenchips beispielsweise in Gehäuse für optoelektronische Bauelemente montiert und elektrisch leitend kontaktiert werden.

Die Druckschrift DE 103 40 004 A1 (AGILENT TECHNOLOGIES INC [US]; 13. Mai 2004) beschreibt eine LED-Lichtquelle gerichtet, bei der ein LED-Chip mittels Elektrophorese selektiv mit einem Leuchtstoff beschichtet wird.

Aus der Druckschrift US 2006/0255355 A1 ist ein LED-Bauteil bekannt, bei dem ein LED-Chip zusammen mit einem Bonddraht in einem Leuchtstoffverguss eingebettet ist.

In der Druckschrift EP 1 267 424 A2 findet sich ein LED-Chip, der mit einer Leuchtstoffschicht mit einer gleichbleibenden Dicke umgeben ist, die mittels Elektrophorese aufgebracht wird, ebenso wie in der Druckschrift US 2002/0185965 A1.

Radial-LED-Bauformen mit einem Leuchtstoff sind in der Druckschrift US 2004/0135162 A1 beschrieben.

Es offenbart die Druckschrift JP 2003-046141 A eine LED, bei der ein Leuchtstoff mittels Sedimentation aufgebracht wird.

Eine LED mit einem Leuchtstoffverguss und einem Reflektorgehäuse ist der Druckschrift US 2004/0211970 A1 zu entnehmen.

Es ist eine Aufgabe, ein Verfahren der eingangs genannten Art bereitzustellen, mit dem optoelektronische Bauelemente herstellbar sind, die eine möglichst große Effizienz aufweisen. Zudem soll ein optoelektronisches Bauelement der eingangs genannten Art angegeben werden, mit dem eine möglichst große Effizienz realisierbar ist. Die vorliegende Erfindung ist in den Ansprüchen 1 und 7 definiert.

Es wird ein Verfahren zum Herstellen eines optoelektronischen Bauelements angegeben, bei dem ein Gehäusegrundkörper mit einer Vertiefung bereitgestellt wird. In der Vertiefung sind ein Lumineszenzdiodenchip und ein freiliegender Teil der Außenfläche mindestens eines ersten elektrischen Leiters angeordnet.

Der freiliegende Teil der Außenfläche muss nicht einstückig ausgebildet sein, sondern kann sich ebenso aus zwei oder mehr voneinander getrennten freiliegenden Teilen der Außenfläche zusammensetzen. "Freiliegend" bedeutet, dass der Teil der Außenfläche des elektrischen Leiters nicht mit elektrisch isolierendem Material bedeckt ist. Der freiliegende Teil kann vollständig unbedeckt oder teilweise oder vollständig mit elektrisch leitfähigem Material bedeckt sein. Wenn der freiliegende Teil des elektrischen Leiters teilweise oder vollständig mit elektrisch leitfähigem Material bedeckt ist, so ist dieses effektiv ein Bestandteil des elektrischen Leiters im Sinne der vorliegenden Anmeldung. In Bezug auf andere Merkmale wie z.B. den Lumineszenzdiodenchip hat der Ausdruck "freiliegende Außenfläche" oder "freiliegende Außenflächen" eine entsprechende Bedeutung.

Bei dem Verfahren wird ein Lumineszenzkonversionsmaterial unter Verwendung von Elektrophorese zumindest auf den freiliegenden Teil der Außenfläche des ersten elektrischen Leiters sowie auf freiliegende elektrisch leitfähige Außenflächen des Lumineszenzdiodenchips aufgebracht.

Somit wird das Lumineszenzkonversionsmaterial nicht nur auf Auskoppelflächen des Lumineszenzdiodenchips, sondern auf alle freiliegenden elektrisch leitfähigen Außenflächen des Lumineszenzdiodenchips aufgebracht, was beispielsweise auch strahlungsundurchlässige elektrische Kontaktelektroden umfasst. Zudem wird das Lumineszenzkonversionsmaterial auf den freiliegenden Teil der Außenfläche des ersten elektrischen Leiters aufgebracht.

Herkömmliche Materialien für elektrische Leiter eines optoelektronischen Bauelements sind in der Regel zumindest teilweise absorbierend für die Primärstrahlung. Die elektrischen Leiter weisen in der Regel Metall auf. Metalle zeigen bei sichtbarer Strahlung generell eine zunehmende Absorption mit abnehmender Wellenlänge. Wenn elektromagnetische Strahlung jedoch statt auf den freiliegenden Teil der Außenfläche des elektrischen Leiters oder auf absorbierende elektrisch leitfähige Außenflächen des Lumineszenzdiodenchips auf das Lumineszenzkonversionsmaterial trifft, so trifft es nicht mehr vollständig auf die darunterliegende Außenfläche. Stattdessen wird es an dem Leuchtstoff des Lumineszenzkonversionsmaterials gestreut oder absorbiert und reemittiert. Insgesamt geht durch die Beschichtung der genannten Flächen mit dem Lumineszenzkonversionsmaterial weniger elektromagnetische Strahlung aufgrund von Absorption verloren, sodass die Effizienz des optoelektronischen Bauelements insgesamt erhöht werden kann.

Es wird ein optoelektronisches Bauelement angegeben, das einen Gehäusegrundkörper mit einer Vertiefung aufweist. In der Vertiefung ist ein Lumineszenzdiodenchip enthalten, der geeignet ist, eine elektromagnetische Primärstrahlung zu emittieren. Zudem ist in der Vertiefung ein freiliegender Teil der Außenfläche mindestens eines ersten elektrischen Leiters angeordnet. Der freiliegende Teil der Außenfläche des ersten elektrischen Leiters und freiliegende, elektrisch leitfähige Außenflächen des Lumineszenzdiodenchips sind mit einem Lumineszenzkonversionsmaterial bedeckt. In der Vertiefung enthaltene, elektrisch isolierende Außenflächen sind im Wesentlichen frei von dem Lumineszenzkonversionsmaterial sind.

"Im Wesentlichen frei" bedeutet, dass die elektrisch isolierenden Außenflächen entweder vollständig frei von dem Lumineszenzkonversionsmaterial sind oder mit derart wenig Lumineszenzkonversionsmaterial versehen sind, dass diese Menge, verglichen mit der Menge an Lumineszenzkonversionsmaterial auf elektrisch leitfähigen Außenflächen in der Vertiefung, vernachlässigbar ist.

Der Gehäusegrundkörper für das Verfahren oder für das optoelektronische Bauelement muss in einer nicht erfindungsgemäßen Abwandlung nicht zwingend eine Vertiefung aufweisen, in der der freiliegende Teil der Außenfläche mindestens eines ersten elektrischen Leiters und der Lumineszenzdiodenchip angeordnet sind.

Bei einer Ausführungsform des Verfahrens weist der Lumineszenzdiodenchip auf einer vom Gehäusegrundkörper abgewandten Seite eine elektrische Kontaktelektrode auf, von der aus ein Bonddraht wegführt. Auf den Bonddraht wird das Lumineszenzkonversionsmaterial ebenfalls unter Verwendung von Elektrophorese aufgebracht.

Bei einer weiteren Ausführungsform des Verfahrens ist in der Vertiefung ein freiliegender Teil der Außenfläche mindestens eines zweiten elektrischen Leiters angeordnet, auf den das Lumineszenzkonversionsmaterial ebenfalls unter Verwendung von Elektrophorese aufgebracht wird.

In einer Ausgestaltung des Verfahrens wird das Lumineszenzkonversionsmaterial auf alle elektrisch leitfähigen Außenflächen von elektrischen Leitern, die in der Vertiefung angeordnet sind, freiliegen und die zur elektrischen oder thermischen Kontaktierung des Lumineszenzdiodenchips dienen, unter Verwendung von Elektrophorese aufgebracht.

Eine weitere Ausgestaltung des Verfahrens sieht vor, dass das Lumineszenzkonversionsmaterial auf alle elektrisch leitfähigen Außenflächen von Materialien, die in der Vertiefung angeordnet sind, freiliegen und Metall aufweisen, unter Verwendung von Elektrophorese aufgebracht wird.

Gemäß einer zusätzlichen Ausführungsform des Verfahrens wird das Lumineszenzkonversionsmaterial auf alle elektrisch leitfähigen Außenflächen, die in der Vertiefung angeordnet sind und freiliegen, unter Verwendung von Elektrophorese aufgebracht.

Bei einer Ausführungsform des optoelektronischen Bauelements weist der Lumineszenzdiodenchip auf einer vom Gehäusegrundkörper abgewandten Seite eine elektrische Kontaktelektrode auf, von der aus ein Bonddraht wegführt. Der Bonddraht ist mit dem Lumineszenzkonversionsmaterial bedeckt.

Bei einer weiteren Ausführungsform des optoelektronischen Bauelements ist in der Vertiefung ein freiliegender Teil der Außenfläche mindestens eines zweiten elektrischen Leiters angeordnet, der von dem Lumineszenzkonversionsmaterial bedeckt ist.

Gemäß einer Ausgestaltung des optoelektronischen Bauelements sind alle elektrisch leitfähigen Außenflächen von elektrischen Leitern, die in der Vertiefung angeordnet sind, freiliegen und die zur elektrischen oder thermischen Kontaktierung des Lumineszenzdiodenchips dienen, mit dem Lumineszenzkonversionsmaterial bedeckt.

Bei einer weiteren Ausgestaltung des optoelektronischen . Bauelements sind alle elektrisch leitfähigen Außenflächen von Materialien, die in der Vertiefung angeordnet sind, freiliegen und Metall aufweisen, mit dem Lumineszenzkonversionsmaterial bedeckt.

In einer zusätzlichen Ausführungsform des optoelektronischen Bauelements ist vorgesehen, dass alle elektrisch leitfähigen Außenflächen, die in der Vertiefung angeordnet sind und freiliegen, mit dem Lumineszenzkonversionsmaterial bedeckt sind.

Weitere Vorteile, Ausführungsformen und Weiterbildungen des Verfahrens und des optoelektronischen Bauelements ergeben sich aus den im Folgenden erläuterten Figuren. Es zeigen:
- Figur 1: eine schematische Schnittansicht eines beispielhaften Gehäusegrundkörpers während eines Verfahrensstadiums eines Ausführungsbeispiels des Verfahrens,
- Figur 2: eine schematische Schnittansicht des optoelektronischen Bauelements gemäß eines ersten Ausführungsbeispiels,
- Figur 3: eine schematische Schnittansicht des optoelektronischen Bauelements gemäß eines zweiten Ausführungsbeispiels,
- Figur 4: eine schematische Schnittansicht des optoelektronischen Bauelements gemäß eines dritten Ausführungsbeispiels,
- Figur 5: eine schematische Schnittansicht eines Ausschnitts des optoelektronischen Bauelements gemäß eines vierten Ausführungsbeispiels,
- Figur 6: eine schematische Draufsicht auf den in Figur 4 dargestellten Ausschnitt, und
- Figur 7: eine schematische Schnittansicht eines Ausschnitts des optoelektronischen Bauelements gemäß einer nicht erfindungsgemäßen Abwandlung.

In den Figuren sind gleiche oder gleich wirkende Bestandteile jeweils mit dem gleichen Bezugszeichen versehen. Die dargestellten Bestandteile sowie die Größenverhältnisse der Bestandteile untereinander sind nicht als maßstabsgerecht anzusehen. Vielmehr sind einige Details der Figuren zum besseren Verständnis übertrieben groß dargestellt.

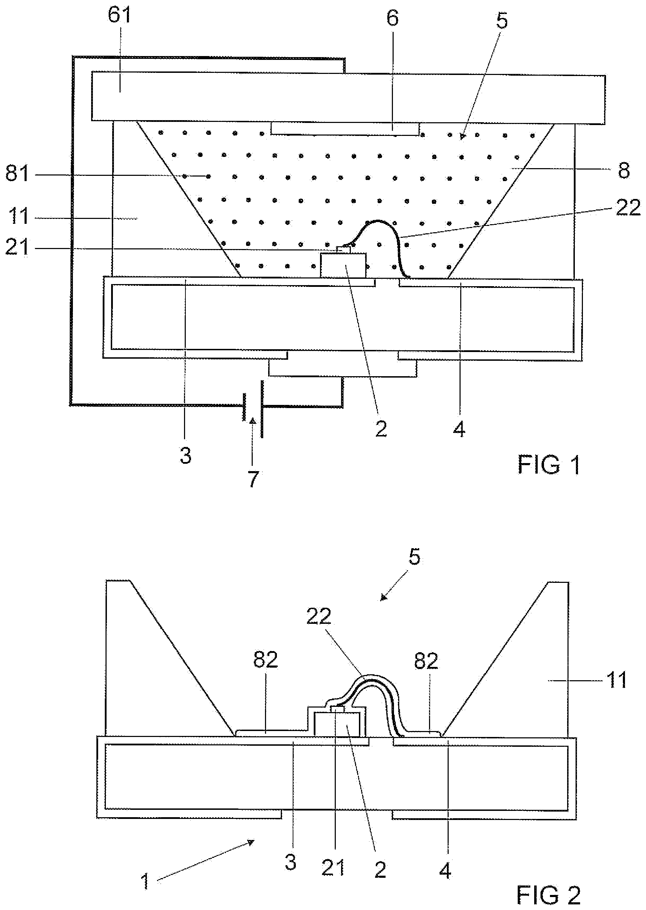

In Figur 1 ist ein Gehäusegrundkörper 11 für ein optoelektronisches Bauelement dargestellt, der für ein Ausführungsbeispiel des Verfahrens bereitgestellt wird. Der Gehäusegrundkörper 11 weist eine Vertiefung 5 auf, in der ein Lumineszenzdiodenchip 2 angeordnet ist.

Der Gehäusegrundkörper 11 wird beispielsweise hergestellt, indem ein Leadframe, das die elektrischen Leiter 3, 4 aufweist, mit einem thermoplastischen oder duroplastischen Material umformt wird. Das Umformen umfasst beispielsweise Spritzpressen oder Spritzgießen. Das Material, mit dem die elektrischen Leiter 3, 4 umformt sind, ist elektrisch isolierend.

Der Lumineszenzdiodenchip 2 emittiert beispielsweise blaues Licht und/oder UV-Strahlung. Er basiert beispielsweise auf einem III-V-Verbindungshalbleiter-Materialsystem und kann insbesondere einen oder mehrere Nitridverbindungshalbleiter aufweisen. Derartige Lumineszenzdiodenchips sind dem Fachmann bekannt. Sie sind insbesondere auch kommerziell erhältlich.

Der Lumineszenzdiodenchip 2 ist auf einer elektrischen Anschlussseite mechanisch und elektrisch mit einem ersten elektrischen Leiter 3 des Gehäusegrundkörpers 11 verbunden. Auf einer Seite, die dem ersten elektrischen Leiter 3 abgewandt ist, weist der Lumineszenzdiodenchip 2 eine elektrische Kontaktelektrode 21 auf, die mittels eines Bonddrahtes 22 elektrisch leitend mit einem zweiten elektrischen Leiter 4 verbunden ist.

Der Lumineszenzdiodenchip 2 besteht beispielsweise vollständig aus elektrisch leitfähigem Material. Somit sind alle Außenflächen des Lumineszenzdiodenchips 2 inklusive der Kontaktelektrode 21, die nicht dem ersten elektrischen Leiter 3 zugewandt sind, freiliegende elektrisch leitfähige Außenflächen des Lumineszenzdiodenchips.

Alternativ kann der Lumineszenzdiodenchip jedoch auch Außenflächen aufweisen, die durch elektrisch isolierendes Material gebildet sind. Beispielsweise können Außenflächen des Lumineszenzdiodenchips teilweise mit elektrisch isolierendem Material wie Siliziumdioxid bedeckt sein. Diese Teile der Außenfläche des Lumineszenzdiodenchips werden bei Verwendung von Elektrophorese im Wesentlichen nicht mit Lumineszenzkonversionsmaterial bedeckt.

Es kann gezielt elektrisch isolierendes Material auf elektrisch leitfähige, freiliegende Außenflächen, die in der Ausnehmung angeordnet sind, aufgebracht werden, um ein Abscheiden von Lumineszenzkonversionsmaterial an bestimmten Stellen zu verhindern.

Bei dem in Figur 1 dargestellten Gehäusegrundkörper ist ein Teil der Außenfläche des ersten elektrischen Leiters 3 und des zweiten elektrischen Leiters 4 in der Vertiefung 5 des Gehäusegrundkörpers 11 freiliegend. Die elektrischen Leiter 3, 4 weisen beispielsweise mindestens ein Metall auf oder sie bestehen aus mindestens einem Metall. Die elektrischen Leiter 3, 4 weisen beispielsweise Gold auf.

Die freiliegenden Flächen der elektrischen Leiter 3, 4 und des Lumineszenzdiodenchips 2 sowie der Bonddraht 22 werden unter Verwendung von Elektrophorese mit einem Lumineszenzkonversionsmaterial versehen. Hierzu ist die Vertiefung 5 mit einer Elektrophorese-Lösung 8 gefüllt. In die Elektrophorese-Lösung 8 ist eine Elektrode 6 getaucht, mittels der die Elektrophorese-Lösung auf ein definiertes elektrisches Potential gesetzt werden kann. Die Elektrode 6 ist an einer Dichtung 61 befestigt, mittels der die Vertiefung 5 des Gehäusegrundkörpers 11 beispielsweise abgedichtet wird.

Die Elektrode 6 ist mit einer Spannungsquelle 7 verbunden. Ebenfalls mit der Spannungsquelle 7 verbunden sind der erste elektrische Leiter 3 und der zweite elektrische Leiter 4. Sie sind gemeinsam an denselben Pol der Spannungsquelle 7 angeschlossen. Zwischen den elektrischen Leitern 3, 4 und der Elektrode 6 wird mittels der Spannungsquelle 7 eine elektrische Spannung angelegt.

Dadurch wird zwischen der Elektrode 6 einerseits und den elektrischen Leitern 3, 4, dem Lumineszenzdiodenchip 2 und dem Bonddraht 22 andererseits ein elektrisches Feld ausgebildet. Das elektrische Feld bewirkt, dass Lumineszenzkonversionsmaterial aus der Elektrophorese-Lösung 8 auf den freiliegenden Außenflächen des ersten elektrischen Leiters 3, des zweiten elektrischen Leiters 4, des Lumineszenzdiodenchips 2 inklusive der elektrischen Kontaktelektrode 21 und des Bonddrahtes 22, die innerhalb der Vertiefung 5 angeordnet sind, selektiv abgelagert wird. Durch die Elektrophorese werden die oben genannten elektrisch leitfähigen freiliegenden Außenflächen, die in der Vertiefung 5 angeordnet sind, vollständig mit Lumineszenzkonversionsmaterial 82 bedeckt, was in Figur 2 schematisch dargestellt ist. Elektrisch nicht leitende Außenflächen, die in der Vertiefung 5 angeordnet sind, werden dagegen im Wesentlichen nicht mit dem Lumineszenzkonversionsmaterial 82 bedeckt. Mittels Elektrophorese lässt sich das Lumineszenzkonversionsmaterial 82 in einer gleichmäßigen, dünnen Schicht aufbringen.

Die Elektrophorese-Lösung 8 weist Leuchtstoffpartikel 81 auf. Beispiele für einen geeigneten Leuchtstoff oder für geeignete Leuchtstoffmischungen sind:
- Chlorosilikate, wie beispielsweise in DE 10036940 und dem dort beschriebenen Stand der Technik offenbart,
- Orthosilikate, Sulfide, Thiometalle und Vanadate wie beispielsweise in WO 00/33390 A1 und dem dort beschriebenen Stand der Technik offenbart,
- Aluminate, Oxide, Halophosphate, wie beispielsweise in US 6616862 und dem dort beschriebenen Stand der Technik offenbart,
- Nitride, Sione und Sialone wie beispielsweise in DE 10147040 und dem dort beschriebenen Stand der Technik offenbart, und
- Granate der Seltenen Erden wie YAG:Ce und der Erdalkalielemente wie beispielsweise in US 2004-062699 und dem dort beschriebenen Stand der Technik offenbart.

Die Elektrophorese-Lösung 8 weist beispielsweise zudem ein Lösungsmittel mit einem Propanol/Aceton-Gemisch auf. Weiterhin ist in der Elektrophorese-Lösung 8 beispielsweise mindestens ein Haftvermittler enthalten, der zum Beispiel ein Nitrat aufweist. Der Haftvermittler enthält beispielsweise Magnesiumnitrat und/oder Yttrium-Nitrat.

Die Elektrophorese als solche sowie geeignete Elektrophorese-Lösungen sind dem Fachmann grundsätzlich bekannt.

Nach dem Aufbringen des Lumineszenzkonversionsmaterials 82 ist das optoelektronische Bauelement 1 beispielsweise bereits fertig gestellt. Optional können natürlich noch weitere Verfahrensschritte bis zur Fertigstellung des Bauelements 1 durchgeführt werden. Zum Beispiel kann die Vertiefung 5 noch mit einer strahlungsdurchlässigen Masse vergossen oder mit einer strahlungsdurchlässigen Abdeckung abgedeckt werden (nicht dargestellt). Es ist auch denkbar, dass eine optische Vorrichtung auf dem Gehäusegrundkörper befestigt wird.

Mittels des Lumineszenzkonversionsmaterials wird die vom Lumineszenzdiodenchip 2 emittierte Primärstrahlung wellenlängenkonvertiert. Die Primärstrahlung weist elektromagnetische Strahlung eines ersten Wellenlängenbereichs auf und die Sekundärstrahlung, das heißt die wellenlängenkonvertierte Primärstrahlung, weist elektromagnetische Strahlung eines zweiten Wellenlängenbereichs auf, der von dem ersten Wellenlängenbereich verschieden ist.

Grundsätzlich können der erste und der zweite Wellenlängenbereich überlappen. Der erste und der zweite Wellenlängenbereich können sich zudem jeweils auch aus mehreren Wellenlängenteilbereichen zusammensetzen, die beispielsweise auch voneinander beabstandet sein können. Bei der Sekundärstrahlung kann das beispielsweise der Fall sein, wenn mehrere verschiedene Leuchtstoffe im Lumineszenzkonversionsmaterial enthalten sind.

Die Sekundärstrahlung weist beispielsweise größere Wellenlängen auf als die Primärstrahlung. Da Metalle häufig mit abnehmender Wellenlänge eine zunehmende Absorption aufweisen, wird die Sekundärstrahlung in diesem Fall weniger stark absorbiert als die Primärstrahlung. Auch aus diesem Grund ist es vorteilhaft, wenn absorbierende Flächen, die durch absorbierendes metallisches Material gebildet sind, mit Lumineszenzkonversionsmaterial 82 versehen sind.

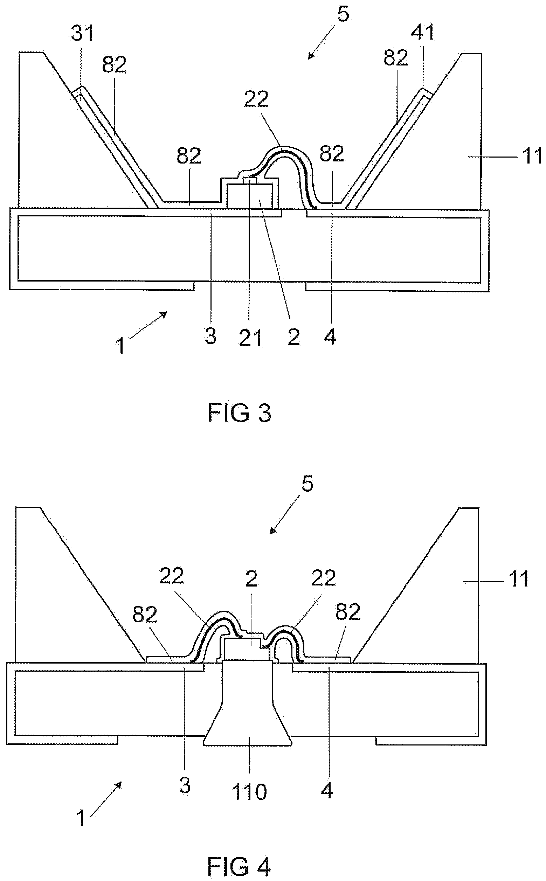

Das in Figur 3 dargestellte optoelektronische Bauelement 1 ist ähnlich wie das vorhergehend anhand Figur 2 erläuterte optoelektronische Bauelement aufgebaut. Ein Unterschied ist jedoch, dass in der Vertiefung 5 ein erster Reflektor 31 und ein zweiter Reflektor 41 enthalten sind. Die Reflektoren 31, 41 sind an seitlichen Innenwänden angeordnet, die durch Material des Gehäusegrundkörpers 11 gebildet sind, welches die Vertiefung 5 lateral umgibt.

Die Reflektoren weisen elektrisch leitfähiges Material auf. Der erste Reflektor 31 ist elektrisch leitfähig mit dem ersten elektrischen Leiter 3 verbunden. Der zweite Reflektor 41 ist elektrisch leitfähig mit dem zweiten elektrischen Leiter 4 verbunden. Die elektrisch leitfähigen freiliegenden Außenflächen der Reflektoren 31, 41 sind mit dem Lumineszenzkonversionsmaterial 82 bedeckt. Das Aufbringen des Lumineszenzkonversionsmaterials 82 erfolgt mittels Elektrophorese.

Im Übrigen ist das Lumineszenzkonversionsmaterial bei allen beschriebenen Ausführungsbeispielen unter Verwendung von Elektrophorese aufgebracht.

Bei dem in Figur 4 dargestellten Ausführungsbeispiel des optoelektronischen Bauelements 1 weist der Gehäusegrundkörper 11 eine Wärmesenke 110 auf. Die Wärmesenke 110 erstreckt sich beispielsweise von der Vertiefung 5 durch einen Boden des Gehäusegrundkörpers zu einer Seite des Gehäusegrundkörpers, die von der Vertiefung 5 abgewandt ist. Der Lumineszenzdiodenchip 2 ist auf der Wärmesenke 110 aufgebracht und thermisch leitfähig mit der Wärmesenke 110 verbunden. Die Wärmesenke 110 weist ein gutleitfähiges Material auf, beispielsweise mindestens ein Metall, oder sie besteht aus einem solchen Material.

Der Lumineszenzdiodenchip 2 ist mittels zweier Bonddrähte 22 elektrisch leitfähig mit dem ersten elektrischen Leiter 3 und dem zweiten elektrischen Leiter 4 verbunden. Freiliegende Außenflächen der elektrischen Leiter 3, 4, der Bonddrähte 22, des Lumineszenzdiodenchips 2 sowie der Wärmesenke 110 sind mit einem Lumineszenzkonversionsmaterial 82 bedeckt.

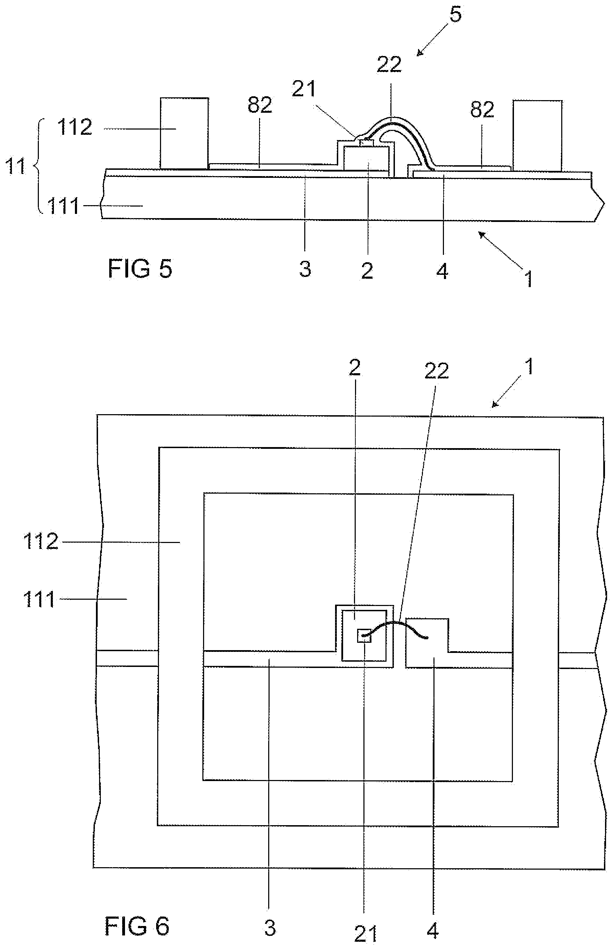

Bei dem in den Figuren 5 und 6 ausschnittsweise dargestelltem optoelektronischen Bauelement 1 weist der Gehäusegrundkörper 11 einen Trägerkörper 111 und einen auf dem Trägerkörper angeordneten Gehäuserahmen 112 auf. Auf dem Trägerkörper 111 sind ein erster elektrischer Leiter 3 und ein zweiter elektrischer Leiter 4 ausgebildet. Die elektrischen Leiter 3, 4 weisen Metall auf oder bestehen aus mindestens einem Metall. Sie weisen beispielsweise Gold auf oder bestehen aus Gold. Die elektrischen Leiter 3, 4 sind beispielsweise auf dem Trägerkörper 111 abgeschieden. Der Trägerkörper 111 weist zum Beispiel ein keramisches Material auf oder besteht aus einem keramischen Material. Der Gehäuserahmen 112 kann beispielsweise ebenfalls ein keramisches Material aufweisen oder aus einem keramischen Material bestehen.

Der Gehäuserahmen 112 ist auf dem Trägerkörper 111 sowie auf den elektrischen Leitern 3, 4 aufgebracht und mechanisch mit dem Trägerkörper 111 verbunden. Der Gehäuserahmen 112 bildet eine Vertiefung 5, er umgibt die Vertiefung 5 lateral.

In der Vertiefung 5 ist ein Lumineszenzdiodenchip 2 auf einem Chipmontageabschnitt des ersten elektrischen Leiters 3 montiert. Mittels eines Bonddrahtes 22 ist eine elektrische Kontaktelektrode 21 des Lumineszenzdiodenchips 2 elektrisch leitend mit einem Bonddraht-Befestigungsabschnitt des zweiten elektrischen Leiters 4 verbunden.

Die in der Vertiefung 5 angeordneten, freiliegenden Außenflächen der elektrischen Leiter 3, 4, des Lumineszenzdiodenchips 2, und des Bonddrahtes 22 sind mit Lumineszenzkonversionsmaterial bedeckt. Die außerhalb der Vertiefung 5 angeordneten freiliegenden Außenflächen der elektrischen Leiter 3, 4 sind frei von Lumineszenzkonversionsmaterial 82. In Figur 6 ist aus Gründen der Übersichtlichkeit das Lumineszenzkonversionsmaterial 82 nicht dargestellt.

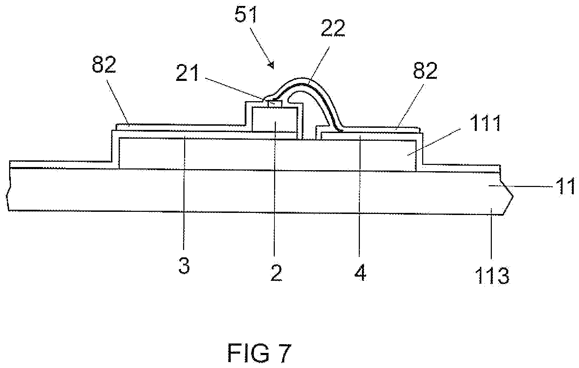

Bei der in Figur 7 dargestellten Abwandlung weist der Gehäusegrundkörper 11 keine Vertiefung, sondern eine Erhebung 51 auf. Die Erhebung 51 ist beispielsweise durch einen auf einer Platte 113 aufgebrachten Trägerkörper 111 gebildet. Ein Lumineszenzdiodenchip 2 ist auf der Erhebung 51 angeordnet.

Freiliegende Außenflächen der elektrischen Leiter 3, 4, des Lumineszenzdiodenchips 2, und des Bonddrahtes 22, die auf der Erhebung 51 angeordnet sind, sind mit Lumineszenzkonversionsmaterial 82 bedeckt. Freiliegende Außenflächen der elektrischen Leiter 3, 4, die sich nicht auf der Erhöhung 51 befinden, sind frei von Lumineszenzkonversionsmaterial.

Alternativ können beispielsweise alle freiliegende Außenflächen der elektrischen Leiter 3, 4, die sich auf einer Vorderseite des Gehäusegrundkörpers 11 befinden, mit Lumineszenzkonversionsmaterial bedeckt sein. Die Vorderseite ist die Hauptseite des Gehäusegrundkörpers 11, auf der sich mindestens ein elektromagnetische Strahlung emittierender Lumineszenzdiodenchip befindet.

Die Anzahl der Lumineszenzdiodenchips und die Anzahl der elektrischen Leiter, die mit Lumineszenzkonversionsmaterial bedeckt werden, können grundsätzlich beliebig groß sein.

Das Verfahren und das optoelektronische Bauelement sind nicht durch die Beschreibung anhand der Ausführungsbeispiele auf diese beschränkt.

## Patentansprüche

1. Verfahren zum Herstellen eines optoelektronischen Bauelements, das einen Lumineszenzdiodenchip (2) aufweist, wobei der Lumineszenzdiodenchip (2) geeignet ist, eine elektromagnetische Primärstrahlunq zu emittieren, wobei ein Lumineszenzkonversionsmaterial (82) unter Verwendung von Elektrophorese auf dem Lumineszenzdiodenchip (2) aufgebracht wird, wobei das Lumineszenzkonversionsmaterial (82) mindestens einen Leuchtstoff enthält, der geeignet ist, die Primärstrahlunq zumindest teilweise in eine Sekundärstrahlunq zu konvertieren, mit den folgenden Schritten:
- Bereitstellen eines Gehäusegrundkörpers (11) mit einer Vertiefung (5), in der der Lumineszenzdiodenchip (2) und ein freiliegender Teil von Außenflächen elektrischer Leiter (3, 4) angeordnet sind, wobei der Gehäusegrundkörper (11) hergestellt wird, indem ein Leadframe, welcher die elektrischen Leiter (3, 4) aufweist, mit einem thermoplastischen oder duroplastischen Material umformt wird, oder indem elektrische Leiter (3, 4) auf einem Trägerkörper (111) abgeschieden werden und ein Gehäuserahmen (112) auf dem Trägerkörper (111) sowie auf den elektrischen Leitern (3, 4) aufgebracht und mechanisch mit dem Trägerkörper (111) verbunden wird, sodass der Gehäuserahmen (112) die Vertiefung (5) bildet und diese lateral umgibt,
**dadurch gekennzeichnet, dass**
nachfolgend der folgende Schritt durchgeführt wird:
- gleichzeitiges Aufbringen des Lumineszenzkonversionsmaterials (82) auf alle freiliegenden Teile der Außenflächen der elektrischen Leiter (3, 4) und auf freiliegende elektrisch leitfähige Außenflächen des Lumineszenzdiodenchips (2) unter Verwendung von Elektrophorese, wobei in der Vertiefung enthaltene, elektrisch isolierende Außenflächen vollständig frei von dem Lumineszenzkonversionsmaterial bleiben.

2. Verfahren nach Anspruch 1,
wobei der Lumineszenzdiodenchip (2) auf einer vom Gehäusegrundkörper (11) abgewandten Seite eine elektrische Kontaktelektrode (21) aufweist, von der aus ein Bonddraht (22) wegführt, auf dem das Lumineszenzkonversionsmaterial (82) ebenfalls unter Verwendung von Elektrophorese aufgebracht wird.

3. Verfahren nach Anspruch 1 oder 2,
wobei in der Vertiefung (5) ein erster Reflektor (31) und ein zweiter Reflektor (41) enthalten sind und die Reflektoren (31, 41) an seitlichen Innenwänden der Vertiefung (5) angeordnet sind, die durch Material des Gehäusegrundkörpers (11) gebildet sind, welches die Vertiefung (5) lateral umgibt.

4. Verfahren nach dem vorhergehenden Patentanspruch,
bei dem die Reflektoren (31, 41) je ein elektrisch leitfähiges Material aufweisen und der erste Reflektor (31) elektrisch leitfähig mit einem ersten der elektrischen Leiter (3) verbunden ist und der zweite Reflektor (41) elektrisch leitfähig mit einem zweiten der elektrischen Leiter (4) verbunden ist,
wobei elektrisch leitfähige freiliegende Außenflächen der Reflektoren (31, 41) beim Schritt des Aufbringens mit dem Lumineszenzkonversionsmaterial (82) bedeckt werden.

5. Verfahren nach einem der vorhergehenden Patentansprüche, bei dem das Lumineszenzkonversionsmaterial (82) auf alle elektrisch leitfähigen Außenflächen von Materialien, die in der Vertiefung angeordnet sind, freiliegen und Metall aufweisen, unter Verwendung von Elektrophorese aufgebracht wird.

6. Verfahren nach einem der vorhergehenden Patentansprüche, bei dem das Lumineszenzkonversionsmaterial (82) ausschließlich auf alle elektrisch leitfähigen Außenflächen, die in der Vertiefung (5) angeordnet sind und freiliegen, unter Verwendung von Elektrophorese aufgebracht wird.

7. Optoelektronisches Bauelement mit
- einem eine Vertiefung (5) aufweisenden Gehäusegrundkörper (11),
- wobei der Gehäusegrundkörper (11) entweder aus einem Leadframe, welcher elektrische Leiter (3, 4) aufweist und welcher mit einem thermoplastischen oder duroplastischen Material umformt ist, besteht oder aus elektrischen Leitern (3, 4) auf einem Trägerkörper (111) und einem Gehäuserahmen (112) auf dem Trägerkörper (111) sowie auf den elektrischen Leitern (3, 4), sodass der Gehäuserahmen (112) die Vertiefung (5) bildet und diese lateral umgibt,
- einem Lumineszenzdiodenchip (2) in der Vertiefung (5), der geeignet ist, eine elektromagnetische Primärstrahlunq zu emittieren und der Außenflächen aufweist, und
- einem Lumineszenzkonversionsmaterial (82),
wobei
- die elektrischen Leiter (3, 4) und der Lumineszenzdiodenchip (2) in der Vertiefung freiliegende Teile von Außenflächen aufweisen, sodass diese Außenflächen unter Vernachlässigung des Lumineszenzkonversionsmaterials (82) nicht mit elektrisch isolierendem Material bedeckt sind, und
- auf allen freiliegenden Teilen der Außenflächen der elektrischen Leiter (3, 4) in der Vertiefung und auf freiliegenden, elektrisch leitfähigen Außenflächen des Lumineszenzdiodenchips (2) das Lumineszenzkonversionsmaterial (82) abgelagert ist, das mindestens einen Leuchtstoff enthält, der geeignet ist, die Primärstrahlung zumindest teilweise in eine Sekundärstrahlung zu konvertieren, wobei
- in der Vertiefung (5) enthaltene, elektrisch isolierende Außenflächen vollständig frei von dem Lumineszenzkonversionsmaterial (82) sind.

8. Optoelektronisches Bauelement nach Patentanspruch 7, wobei der Lumineszenzdiodenchip (2) auf einer vom Gehäusegrundkörper (11) abgewandten Seite eine elektrische Kontaktelektrode (21) aufweist, von der aus ein Bonddraht wegführt (22), auf dem das Lumineszenzkonversionsmaterial (82) abgelagert ist.

## Claims

1. Method for producing an optoelectronic component comprising a luminescence diode chip (2), wherein the luminescence diode chip (2) is suitable for emitting an electromagnetic primary radiation, wherein a luminescence conversion material (82) is applied on the luminescence diode chip (2) using electrophoresis, wherein the luminescence conversion material (82) contains at least one phosphor suitable for at least partly converting the primary radiation into a secondary radiation, comprising the following steps:
- providing a housing main body (11) having a depression (5), in which the luminescence diode chip (2) and an exposed part of outer surfaces of electrical conductors (3, 4) are arranged, wherein the housing main body (11) is produced by a thermoplastic or thermosetting plastic material being moulded around a leadframe comprising the electrical conductors (3, 4), or by electrical conductors (3, 4) being deposited on a carrier body (111) and a housing frame (112) being applied on the carrier body (111) and also on the electrical conductors (3, 4) and being mechanically connected to the carrier body (111), such that the housing frame (112) forms the depression (5) and laterally surrounds the latter,
**characterized in that**
the following step is subsequently carried out:
- simultaneously applying the luminescence conversion material (82) on all exposed parts of the outer surfaces of the electrical conductors (3, 4) and on exposed electrically conductive outer surfaces of the luminescence diode chip (2) using electrophoresis, wherein electrically insulating outer surfaces contained in the depression remain completely free of the luminescence conversion material.

2. Method according to Claim 1,
wherein the luminescence diode chip (2) comprises an electrical contact electrode (21) on a side facing away from the housing main body (11), a bond wire (22) leading away from said electrical contact electrode, on which bond wire the luminescence conversion material (82) is likewise applied using electrophoresis.

3. Method according to Claim 1 or 2,
wherein a first reflector (31) and a second reflector (41) are contained in the depression (5) and the reflectors (31, 41) are arranged at lateral inner walls of the depression (5), which are formed by material of the housing main body (11) which laterally surrounds the depression (5).

4. Method according to the preceding patent claim,
wherein the reflectors (31, 41) each comprise an electrically conductive material and the first reflector (31) is electrically conductively connected to a first of the electrical conductors (3) and the second reflector (41) is electrically conductively connected to a second of the electrical conductors (4),
wherein electrically conductive exposed outer surfaces of the reflectors (31, 41) are covered with the luminescence conversion material (82) during the applying step.

5. Method according to any of the preceding patent claims, wherein the luminescence conversion material (82) is applied on all electrically conductive outer surfaces of materials which are arranged in the depression, are exposed and comprise metal, using electrophoresis.

6. Method according to any of the preceding patent claims, wherein the luminescence conversion material (82) is applied exclusively on all electrically conductive outer surfaces which are arranged in the depression (5) and are exposed, using electrophoresis.

7. Optoelectronic component comprising
- a housing main body (11) having a depression (5),
- wherein the housing main body (11) consists either of a leadframe, which comprises electrical conductors (3, 4) and around which a thermoplastic or thermosetting plastic material is moulded, or of electrical conductors (3, 4) on a carrier body (111) and a housing frame (112) on the carrier body (111) and also on the electrical conductors (3, 4), such that the housing frame (112) forms the depression (5) and laterally surrounds the latter,
- a luminescence diode chip (2) in the depression (5), said luminescence diode chip being suitable for emitting an electromagnetic primary radiation and having outer surfaces, and
- a luminescence conversion material (82),
wherein
- the electrical conductors (3, 4) and the luminescence diode chip (2) in the depression have exposed parts of outer surfaces, such that said outer surfaces, disregarding the luminescence conversion material (82), are not covered with electrically insulating material, and
- the luminescence conversion material (82) is deposited on all exposed parts of the outer surfaces of the electrical conductors (3, 4) in the depression and on exposed, electrically conductive outer surfaces of the luminescence diode chip (2), said luminescence conversion material containing at least one phosphor suitable for at least partly converting the primary radiation into a secondary radiation,
wherein
- electrically insulating outer surfaces contained in the depression (5) are completely free of the luminescence conversion material (82).

8. Optoelectronic component according to Patent Claim 7, wherein the luminescence diode chip (2) comprises an electrical contact electrode (21) on a side facing away from the housing main body (11), a bond wire (22) leading away from said electrical contact electrode, on which bond wire the luminescence conversion material (82) is deposited.

## Revendications

1. Procédé de fabrication d'un composant optoélectronique, qui comprend une puce à diode électroluminescente (2) conçue pour émettre un rayonnement électromagnétique primaire, dans lequel un matériau de conversion de luminescence (82) est appliqué par électrophorèse sur la puce à diode luminescente (2), le matériau de conversion de luminescence (82) contenant au moins une substance luminescente adaptée pour convertir le rayonnement primaire au moins en partie en un rayonnement secondaire, le procédé comprenant les étapes suivantes :
- fourniture d'un corps de base de boîtier (11) pourvu d'une cavité (5), dans laquelle la puce à diode électroluminescente (2) et une partie exposée de surfaces extérieures de conducteurs électriques (3, 4) sont disposées, le corps de base de boîtier (11) étant fabriqué en refaçonnant un cadre de connexion, qui contient les conducteurs électriques (3, 4), avec un matériau thermoplastique ou thermodurcissable ou en séparant des conducteurs électriques (3, 4) sur un support (111) et en appliquant un cadre de boîtier (112) sur le support ainsi que sur les conducteurs électriques (3, 4) et en le reliant mécaniquement au support (11), de telle sorte que le cadre de boîtier (112) forme la cavité (5), et l'entoure latéralement,
**caractérisé en ce que**
l'étape suivante est exécutée ensuite :
- application simultanée du matériau de conversion de luminescence (82) sur toutes les parties exposées des surfaces extérieures des conducteurs électriques (3, 4) et sur toutes les surfaces extérieures exposées électriquement conductrices de la puce à diode électroluminescente (2) par électrophorèse, selon laquelle des surfaces extérieures électriquement isolantes contenues dans la cavité sont complètement exemptes du matériau de conversion de luminescence.

2. Procédé selon la revendication 1,
dans lequel la puce à diode électroluminescente (2) comporte une électrode de contact (21) électrique sur une face opposée au corps de base de boîtier (11), à partir de laquelle un fil de connexion (22) s'étend, sur lequel le matériau de conversion de luminescence (82) est appliqué également par électrophorèse.

3. Procédé selon la revendication 1 ou 2,
dans lequel un premier réflecteur (31) et un second réflecteur (41) sont contenus dans la cavité (5) et les réflecteurs (31, 41) sont disposés sur les parois intérieures latérales de la cavité (5) formées par le matériau du corps de base de boîtier (11) qui entoure latéralement la cavité (5).

4. Procédé selon la revendication précédente,
dans lequel les réflecteurs (31, 41) comprennent chacun un matériau électriquement conducteur et le premier réflecteur (31) est connecté de façon électriquement conductrice avec un premier conducteur électrique (3) et le second réflecteur (41) est connecté de façon électriquement conductrice avec un second conducteur électrique (4), et
des surfaces extérieures exposées, électriquement conductrices des réflecteurs (31, 41) sont recouvertes du matériau de conversion de luminescence (82) à l'étape de son application.

5. Procédé selon l'une quelconque des revendications précédentes,
dans lequel le matériau de conversion de luminescence (82) est appliqué par électrophorèse sur toutes les surfaces électriquement conductrices des matériaux qui sont disposées dans la cavité, qui sont exposées et comportent du métal.

6. Procédé selon l'une quelconque des revendications précédentes,
dans lequel le matériau de conversion de luminescence (82) est appliqué par électrophorèse exclusivement sur toutes les surfaces électriquement conductrices qui sont disposées dans la cavité (5) et sont exposées.

7. Composant optoélectronique comprenant
- un corps de base de boîtier (11) comportant une cavité (5),
le corps de base de boîtier (11) étant constitué d'une grille de connexion qui comprend des conducteurs électriques (3, 4) et qui est refaçonnée avec un matériau thermoplastique ou thermodurcissable,
ou étant constitué de conducteurs électriques (3, 4) sur un support (111) et d'un cadre de boîtier (112) appliqué sur le support (111) ainsi que sur les conducteurs électriques (3, 4), de telle sorte que le cadre de boîtier (112) forme la cavité (5), et l'entoure latéralement,
- une puce à diode électroluminescente (2) dans la cavité (5), qui est conçue pour émettre un rayonnement électromagnétique primaire et comprend des surfaces extérieures, et
- un matériau de conversion de luminescence (82), dans lequel
- les conducteurs électriques (3, 4) et la puce à diode électroluminescente (2) comportent dans la cavité des parties exposées de surfaces extérieures de telle manière que ces surfaces extérieures ne sont pas recouvertes d'un matériau électriquement isolant, en négligeant le matériau de conversion de luminescence (82), et
- le matériau de conversion de luminescence (82), contenant au moins une substance luminescente adaptée pour convertir le rayonnement primaire au moins en partie en un rayonnement secondaire, est déposé sur toutes les parties exposées des surfaces extérieures des conducteurs électriques (3, 4) dans la cavité et sur toutes les surfaces extérieures exposées, électriquement conductrices de la puce à diode électroluminescente (2), et
- des surfaces extérieures électriquement isolantes contenues dans la cavité (5) sont complètement exemptes du matériau de conversion de luminescence (82).

8. Composant optoélectronique selon la revendication 7, dans lequel la puce à diode électroluminescente (2) comporte une électrode de contact (21) électrique sur une face opposée au corps de base de boîtier (11), à partir de laquelle un fil de connexion (22) s'étend, sur lequel le matériau de conversion de luminescence (82) est déposé.
